# EUROPEAN PATENT APPLICATION

(11) **EP 4 722 847 A1**
(43) Date of publication of application: **08.04.2026**
(21) Application number: 23940609.3
(22) Date of filing: 05.06.2023
(51) Int. Cl.: G06F 1/16, H05K 5/02

(54) **ELECTRONIC DEVICE**

(71) Applicant: Panasonic Intellectual Property Management Co., Ltd., Kadoma-shi, Osaka 571-0057 (JP)
(72) Inventor: KANAZAWA, Toshihide, Kadoma-shi, Osaka 571-0057 (JP)
(74) Representative: Eisenführ Speiser
(86) International application number: PCT/JP2023/020899
(87) International publication number: WO 2024/252502

(57) **Abstract**

This electronic device comprises a first housing, a second housing having a fitting part, and an elastic body. The first housing has at least one fitted part that is fitted to the fitting part by being slid in a first direction, and a first housing side peripheral edge part that is provided to a peripheral edge of the first housing. The elastic body is positioned between the fitted part and the first housing side peripheral edge part at the time of fitting.

## Description

### TECHNICAL FIELD

The present disclosure relates to an electronic device.

### BACKGROUND ART

Patent Literature 1 discloses a housing of an electronic device including a first wall, a second wall protruding in a first direction intersecting the first wall, a first member provided with an accommodation portion opened in the first direction, a third wall covering at least a part of the accommodation portion, a second member having a fourth wall provided with a through hole penetrating from the third wall in a tolerance direction intersecting the first direction, a seal member interposed between an end surface of the second wall in the first direction and the third wall, and a third member. In the housing of the electronic device, one of the second wall and the third member is provided with an opening portion overlapping the through hole in the tolerance direction, and the other of the second wall and the third member is provided with a shaft portion inserted into the through hole and the opening portion in a state in which the seal member is compressed in the first direction.

### CITATION LIST

### PATENT LITERATURE

Patent Literature 1: JP2020-135752A

### SUMMARY OF INVENTION

### TECHNICAL PROBLEM

The present disclosure has been made in view of the circumstances of the related art described above, and an object thereof is to provide an electronic device that more effectively prevents rattling of the electronic device after assembly.

### SOLUTION TO PROBLEM

The present disclosure provides an electronic device including: a first housing; a second housing including a fitting portion; and an elastic body, in which the first housing includes at least one fitted portion configured to be fitted to the fitting portion by being slid along a first direction, and a first housing side peripheral edge portion provided on a peripheral edge of the first housing, and the elastic body is positioned between the fitted portion and the first housing side peripheral edge portion during the fitting.

### ADVANTAGEOUS EFFECTS OF INVENTION

According to the present disclosure, it is possible to more effectively prevent rattling of an electronic device after assembly.

### BRIEF DESCRIPTION OF DRAWINGS

[Fig. 1] Fig. 1 is a diagram illustrating a use case example of an electronic device.
[Fig. 2] Fig. 2 is a diagram illustrating an installation example of the electronic device.
[Fig. 3] Fig. 3 is a diagram illustrating a back surface of the electronic device.
[Fig. 4] Fig. 4 is a diagram illustrating an example of fitting between a monitor and a cover.
[Fig. 5] Fig. 5 is a diagram illustrating an inner surface of the cover.
[Fig. 6] Fig. 6 is a diagram illustrating a back surface of the monitor.
[Fig. 7] Fig. 7 is an A-A cross-sectional view illustrating an example of fitting between the monitor and the cover on an upper surface of the electronic device.
[Fig. 8] Fig. 8 is an enlarged view of a main portion of a B-B cross section illustrating the example of fitting between the monitor and the cover on the upper surface of the electronic device.
[Fig. 9] Fig. 9 is an enlarged view of a main portion of a C-C cross section illustrating an example of fitting between the monitor and the cover on a side surface of the electronic device.
[Fig. 10] Fig. 10 is an enlarged view of a main portion of a D-D cross section illustrating a state of a fitting portion, an annular elastic body, and a first claw portion during fitting.
[Fig. 11] Fig. 11 is a diagram illustrating an example of the fitting portion.
[Fig. 12] Fig. 12 is an enlarged view of a main portion of a B-B cross section illustrating an example of fitting between a monitor and a cover in a modification of the embodiment.

### DESCRIPTION OF EMBODIMENTS

### (Background of Present Disclosure)

In a modern aircraft, each seat is provided with an electronic device such as a personal monitor that can be used to watch movies, play games, read, check flight status, or the like, or a seat monitor capable of providing other in-flight entertainment. When repairing such an electronic device on an aircraft, a manager (for example, a mechanic of the aircraft or a cabin crew) needs to remove the electronic device from each seat and disassemble the electronic device. However, in a case in which the electronic device is assembled using a large number of screws, bolts, or the like, there is a possibility that the manager may lose a removed component such as a screw or a bolt, and there is a possibility that the electronic device cannot be repaired.

As shown in PATENT LITERATURE 1, there is a housing of an electronic device in which two members (that is, the first member and the second member) can be fitted (assembled) without using a screw or the like. In the housing of the electronic device, since it is necessary to disassemble all side covers provided on the respective sides of the housing having a substantially rectangular shape, the number of disassembled components is large, and there is a problem in terms of the number of disassembled components.

In addition, since a housing of an electronic device installed in an aircraft needs to pass an Emission (EMI) test, the housing may be made of metal. Since a housing made of resin has elasticity, it is easy to fill a gap formed between components due to a dimensional tolerance. However, it is difficult for a housing made of metal to fill a gap formed between components, and when an external force such as vibration is applied to the housing, there is a problem that rattling occurs between parts constituting the housing due to the formed gap.

Hereinafter, embodiments specifically disclosing configurations and operations of an electronic device according to the present disclosure will be described in detail with reference to the drawings as appropriate. However, unnecessarily detailed description may be omitted. For example, detailed description of well-known matters and redundant description of substantially the same configuration may be omitted. This is to avoid unnecessary redundancy of the following descriptions and to facilitate understanding of those skilled in the art. The accompanying drawings and the following description are provided for those skilled in the art to fully understand the present disclosure, and are not intended to limit the subject matters described in the claims.

Hereinafter, in each drawing, an X direction and a Y direction form a horizontal plane and are directions orthogonal to each other in the horizontal plane. The X direction is along a lateral direction of the electronic device TB. The Y direction is a direction along a longitudinal direction of the electronic device TB, the Y direction may be referred to as an upward direction, and a direction opposite to the Y direction may be referred to as a downward direction. A Z direction is along a thickness direction of the electronic device TB, the Z direction may be referred to as a front direction, and a direction opposite to the Z direction may be referred to as a rear direction.

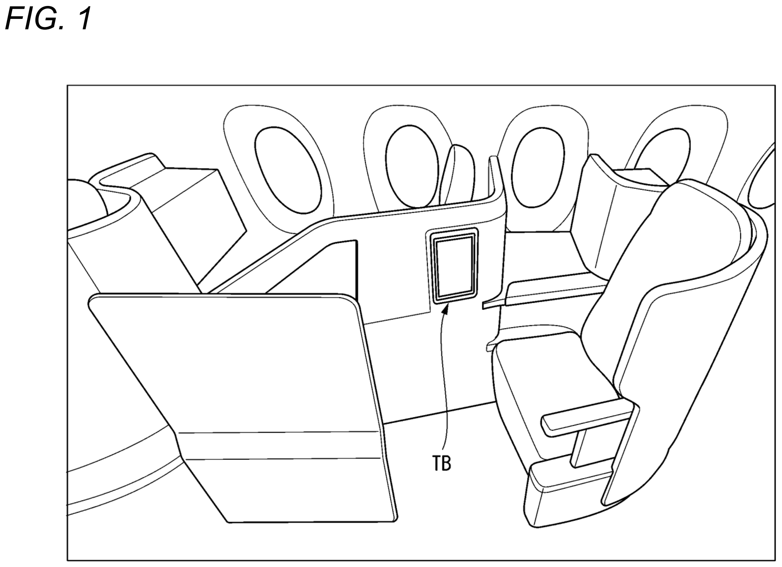

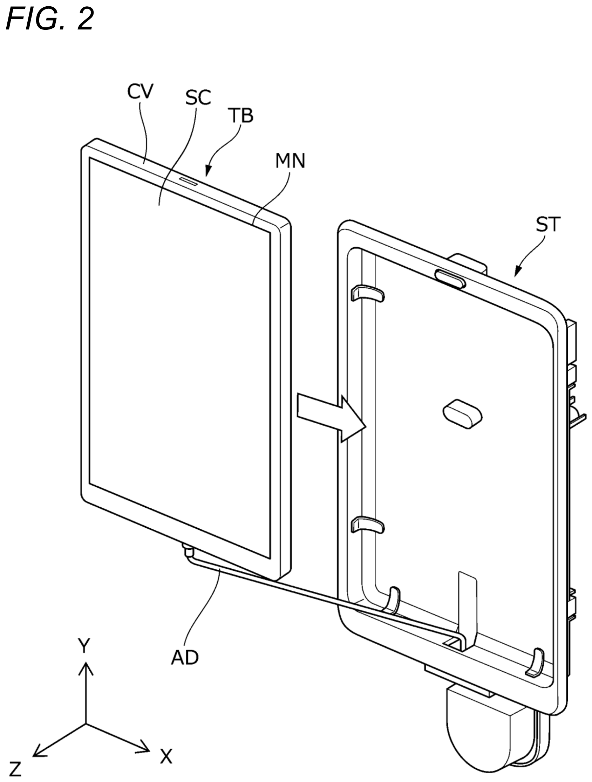

First, a use case example of the electronic device TB will be described with reference to Figs. 1 and 2. Fig. 1 is a diagram illustrating the use case example of the electronic device TB. Fig. 2 is a diagram illustrating an installation example of the electronic device TB. It is needless to say that the use case illustrated in Fig. 1 is an example and the present disclosure is not limited thereto.

The electronic device TB is, for example, a personal monitor that can be used to watch movies, play games, read, check flight status, or the like, a seat monitor capable of providing in-flight entertainment, or a tablet personal computer. The electronic device TB is fixedly installed on a seat of a vehicle such as an aircraft or an installation table ST in the seat, and is used by a user (for example, a passenger, or an occupant).

The electronic device TB includes a monitor MN (an example of a first housing) and a cover CV (an example of a second housing) each formed of a rigid material such as metal or carbon fiber. The electronic device TB is integrally implemented by fitting the monitor MN and the cover CV together. The electronic device TB is used by a user by being installed on the installation table ST with an adapter AD capable of supplying power to the electronic device TB connected.

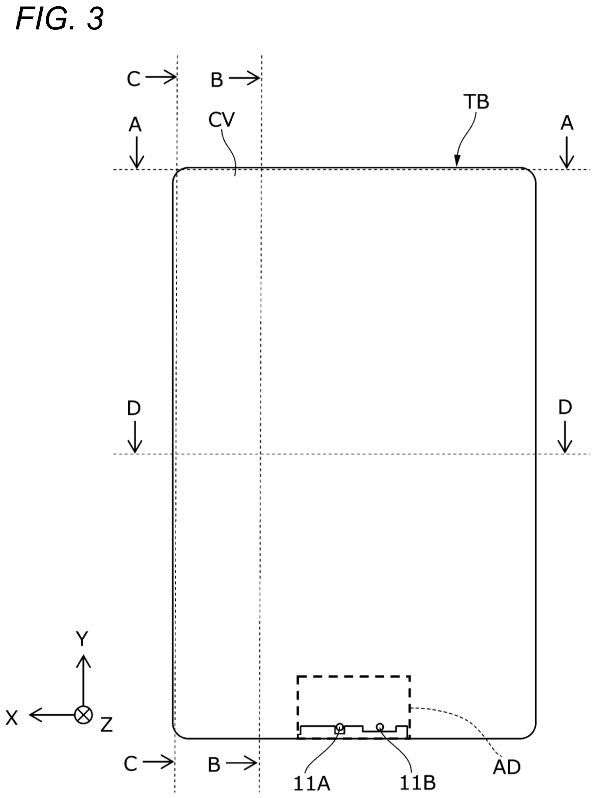

Next, a back structure of the electronic device TB will be described with reference to Fig. 3. Fig. 3 is a diagram illustrating a back surface of the electronic device TB. The electronic device TB illustrated in Fig. 3 is in a state in which the monitor MN and the cover CV are fitted to each other, and the adapter AD is not illustrated.

The adapter AD (see Fig. 2) is connected to the back surface of the electronic device TB from a direction opposite to the Y direction. In the electronic device TB, the monitor MN and the cover CV in the fitted state are screwed with two screws 11A and 11B at a position corresponding to a connection point of the adapter AD.

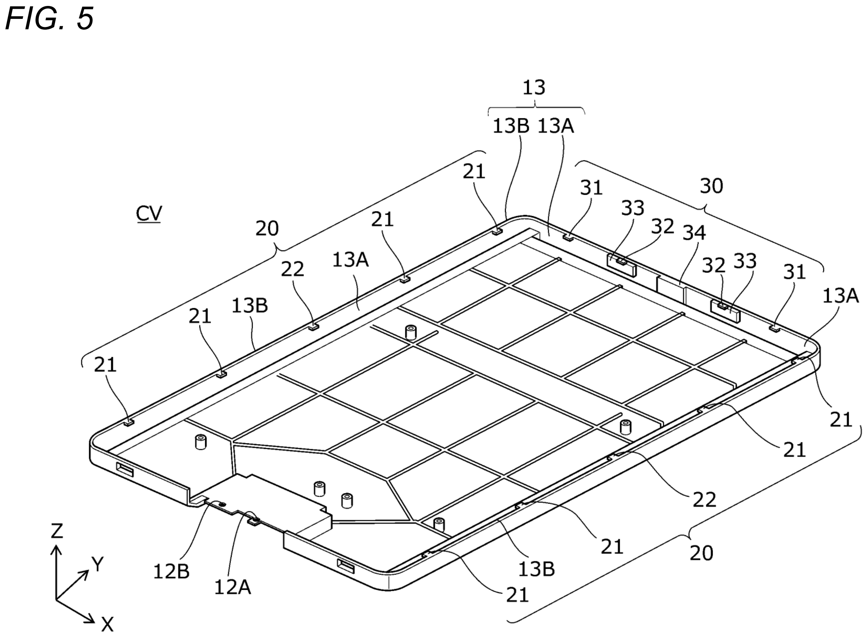

Specifically, in the electronic device TB, two screws 11A and 11B are inserted into two insertion holes 12A and 12B (see Fig. 5) provided on the cover CV, respectively, and are screwed into screw holes (not illustrated) provided on a back surface of the monitor MN. In the electronic device TB, when the adapter AD is connected in a state in which the two screws 11A and 11B are screwed, screwed points of the two screws 11A and 11B are covered by the adapter AD. Accordingly, the electronic device TB can protect the adapter AD and the connection point of the adapter AD from vibration caused by the aircraft.

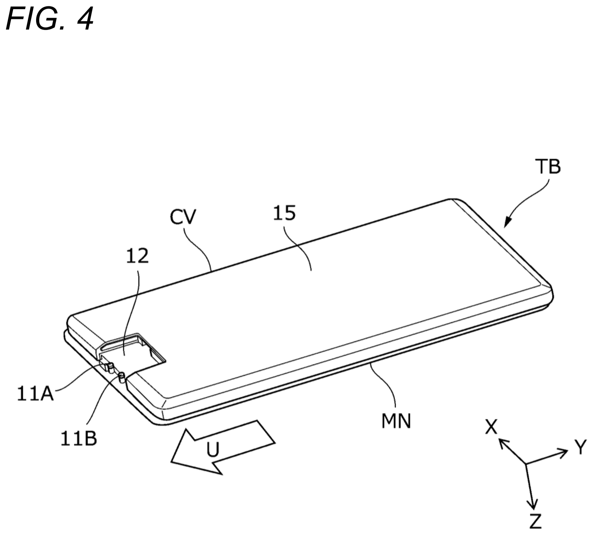

Next, fitting of the electronic device TB will be described with reference to Fig. 4. Fig. 4 is a diagram illustrating an example of fitting between the monitor MN and the cover CV. The electronic device TB illustrated in Fig. 4 is in a state in which the monitor MN and the cover CV are not fitted.

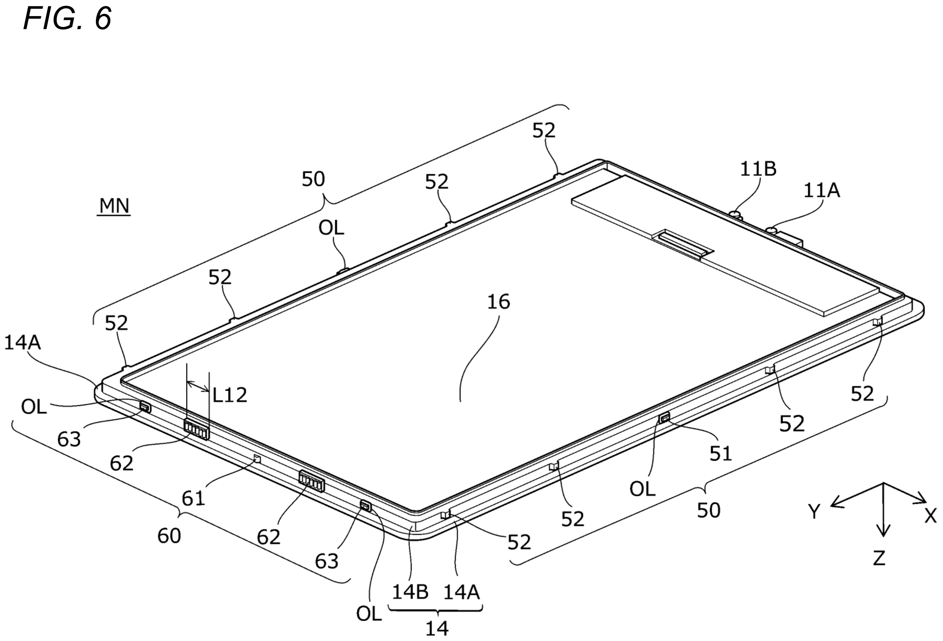

In the electronic device TB, the cover CV and the monitor MN are fitted to each other by sliding the cover CV in a sliding direction U along the longitudinal direction of the electronic device TB in a state in which a peripheral edge portion 13B (see Fig. 5) of the cover CV is in contact with a step portion 14A (an example of a first housing side peripheral edge portion of the monitor MN, see Fig. 6) of the monitor MN.

Next, a fitting structure of the cover CV will be described with reference to Fig. 5. Fig. 5 is a diagram illustrating the fitting structure of the cover CV. The cover CV illustrated in Fig. 5 is a surface facing the back surface of the monitor MN illustrated in Fig. 6 during fitting.

The cover CV is formed in a substantially rectangular shape and includes a back surface portion 15 and a second housing side peripheral edge portion 13 formed around the back surface portion 15 so as to be substantially orthogonal to the back surface portion 15. The second housing side peripheral edge portion 13 is formed substantially parallel to a display portion SC of the monitor MN, and includes the peripheral edge portion 13B formed in a substantially rectangular shape and an inner surface 13A formed continuously in a direction substantially orthogonal to the peripheral edge portion 13B. The inner surface 13A connects the peripheral edge portion 13B and the back surface portion 15 of the cover CV.

The cover CV is provided with a pair of second housing side surface fitting portions 20 on the peripheral edge portion 13B of the second housing side peripheral edge portion 13 along the longitudinal direction. The cover CV includes, along a short side direction, an adapter receiving portion 12 to which the adapter AD or a cord connected to the adapter AD is connected on a side opposite to the Y direction, and a second housing upper surface fitting portion 30 on the inner surface 13A on a Y direction side (upper surface side) facing the side on which the adapter receiving portion 12 is provided. The adapter receiving portion 12 is formed to be recessed toward a front side of the monitor MN as compared with a back surface portion 16. The adapter receiving portion 12 includes two insertion holes 12A and 12B.

Each of the pair of second housing side surface fitting portions 20 is fitted to, by the sliding operation described above, each of a pair of first housing side surface fitted portions 50 respectively provided on a side surface along the longitudinal direction of the monitor MN. Each of the pair of second housing side surface fitting portions 20 is fitted to each of the pair of first housing side surface fitted portions 50, thereby regulating vibration and movement of the monitor MN and the cover CV in the X direction and the Z direction.

The second housing side surface fitting portion 20 includes a plurality of first side surface fitting portions 21 (an example of other fitting portion) and a second side surface fitting portion 22 (an example of a fitting portion) formed substantially parallel to the display portion SC of the monitor MN in the second housing side peripheral edge portion 13. The number and arrangement of the first side surface fitting portion 21 and the second side surface fitting portion 22 illustrated in Fig. 5 are examples, and the present invention is not limited thereto.

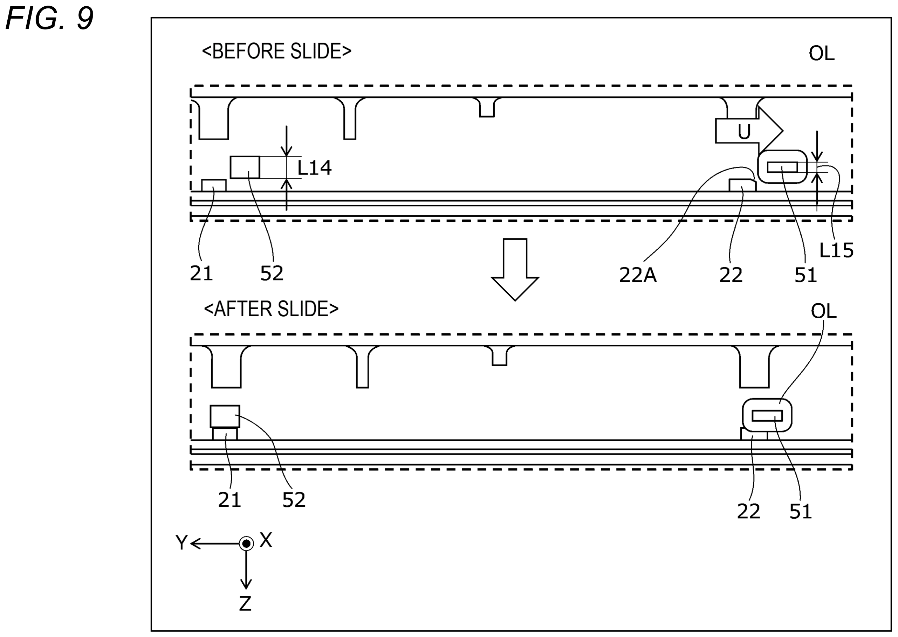

The second side surface fitting portion 22 is formed with a C surface 22A (an example of an inclined portion, see Fig. 9) on a surface on a side along the sliding direction U, that is on a surface that comes into contact with an annular elastic body OL by the sliding operation. Accordingly, the second side surface fitting portion 22 slides on the step portion 14A of a first housing side peripheral edge portion 14 during the sliding operation, and easily enters between the step portion 14A and the annular elastic body OL included in the first housing side surface fitted portion 50.

The second housing upper surface fitting portion 30 is fitted to a first housing upper surface fitted portion 60 provided on an upper surface of the monitor MN by the sliding operation described above. The second housing upper surface fitting portion 30 is fitted to the first housing upper surface fitted portion 60, thereby regulating vibration and movement of the monitor MN and the cover CV in the Y direction and the Z direction.

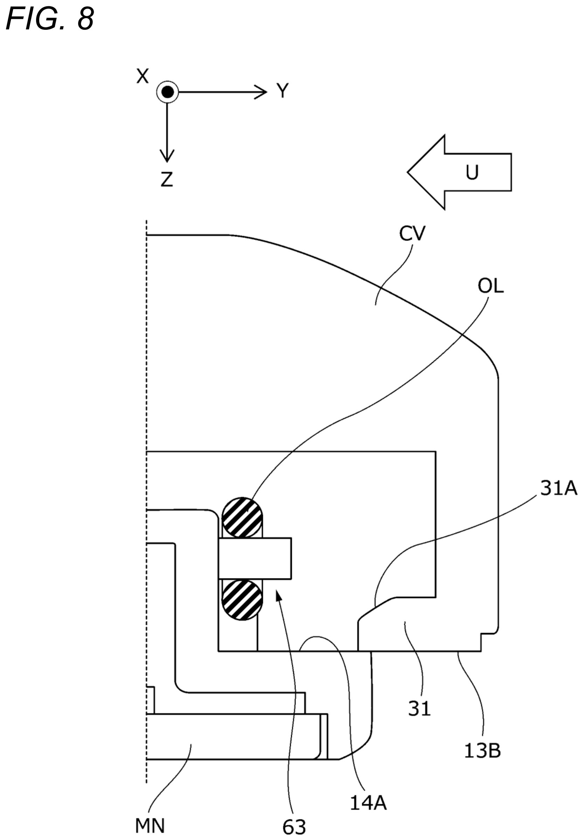

The second housing upper surface fitting portion 30 includes first upper surface fitting portions 31 (an example of the fitting portion), second upper surface fitting portions 32 (other fitting portion, an example of an uneven fitting portion), vibration absorbing members 33, and a contact portion 34. The first upper surface fitting portion 31 is formed with a C surface 31A (an example of the inclined portion, see Fig. 8) along which the thickness of the first upper surface fitting portion 31 in the Z direction gradually decreases along the sliding direction U. Accordingly, the first upper surface fitting portion 31 easily enters between the step portion 14A and an annular elastic body OL during fitting. The number and arrangement of the first upper surface fitting portion 31, the second upper surface fitting portion 32, the vibration absorbing member 33, and the contact portion 34 illustrated in Fig. 5 are examples, and the present invention is not limited thereto.

The vibration absorbing member 33 is made of a material capable of absorbing vibration, such as sponge. The vibration absorbing member 33 comes into contact with uneven portions 62 formed on a side surface 14B on the upper surface side of the monitor MN by the sliding operation, and absorbs vibration along the Y direction between the cover CV and the monitor MN.

The first side surface fitting portion 21, the second side surface fitting portion 22, the first upper surface fitting portion 31, and the second upper surface fitting portion 32 may be provided on the inner surface 13A side without being continuous with the peripheral edge portion 13B.

Next, a fitting structure of the monitor MN will be described with reference to Fig. 6. Fig. 6 is a diagram illustrating an example of the fitting structure of the monitor MN. The monitor MN illustrated in Fig. 6 is a surface facing the inner surface of the cover CV illustrated in Fig. 5 during fitting.

The monitor MN is formed in a substantially rectangular shape and includes the back surface portion 16 of the monitor MN and the first housing side peripheral edge portion 14 formed around the back surface portion 16 so as to be substantially orthogonal to the back surface portion 16. The first housing side peripheral edge portion 14 is formed substantially parallel to the display portion SC of the monitor MN, and includes the step portion 14Aon which the peripheral edge portion 13B of the cover CV slides during sliding, and the side surface 14B connecting the step portion 14A and the back surface portion 16 in a direction substantially orthogonal to the step portion 14A.

In the monitor MN, the first housing side surface fitted portions 50 are provided on the side surface 14B of the first housing side peripheral edge portion 14 along the longitudinal direction, respectively. The monitor MN is provided with screw holes (not illustrated) into which the two screws 11A and 11B can be screwed, respectively, on the side surface 14B on a side opposite to the Y direction along the short side direction of the first housing side peripheral edge portion 14, and includes the first housing upper surface fitted portion 60 on the Y direction side, that is, on the side surface 14B on a side (upper surface) facing the side into which the two screws 11A and 11B are screwed.

Each of the pair of first housing side surface fitted portions 50 is fitted to each of the pair of second housing side surface fitting portions 20 provided in the longitudinal direction of the cover CV by the sliding operation described above. Each of the pair of first housing side surface fitted portions 50 is fitted to each of the pair of second housing side surface fitting portions 20, thereby regulating vibration and movement of the monitor MN and the cover CV in the X direction and the Z direction.

The first housing side surface fitted portion 50 includes a first side surface fitted portion 51 (an example of the fitted portion) and second side surface fitted portions 52 (an example of other fitted portion). The number and arrangement of the first side surface fitted portion 51 and the second side surface fitted portion 52 illustrated in Fig. 6 are examples, and the present invention is not limited thereto.

The first side surface fitted portion 51 has the annular elastic body OL (an example of an elastic body) attached thereto. The annular elastic body OL is made of, for example, rubber. For example, at least one first side surface fitted portion 51 may be provided. The first side surface fitted portion 51 may have the same size as a second upper surface fitted portion 63 provided on the first housing upper surface fitted portion 60. Accordingly, in the electronic device TB, the annular elastic body OL attached to the first side surface fitted portion 51 and the second upper surface fitted portion 63 can be shared, and maintenance can be facilitated.

A thickness L14 of the second side surface fitted portion 52 in the Z direction is larger than a thickness L15 of the first side surface fitted portion 51. Accordingly, in the electronic device TB, the annular elastic body OL can be effectively prevented from being erroneously attached to the second side surface fitted portion 52 when the annular elastic body OL is attached or replaced.

The first housing upper surface fitted portion 60 is fitted to the second housing upper surface fitting portion 30 provided on the upper surface of the cover CV by the sliding operation described above. The first housing upper surface fitted portion 60 is fitted to the second housing upper surface fitting portion 30, thereby regulating vibration and movement of the monitor MN and the cover CV in the Y direction and the Z direction.

The first housing upper surface fitted portion 60 includes a first upper surface fitted portion 61, an uneven portion 62 (an example of other fitted portion), and a second upper surface fitted portion 63 (an example of a fitted portion). The number and arrangement of a first upper surface fitted portion 61, the uneven portion 62, and the second upper surface fitted portion 63 illustrated in Fig. 6 are examples, and the present invention is not limited thereto. For example, at least one first upper surface fitted portion 61, at least one uneven portion 62, and at least one second upper surface fitted portion 63 may be provided.

The first upper surface fitted portion 61 is formed on the side surface 14B on the upper surface positioned in the Y direction. The contact portion 34 comes into contact with the first upper surface fitted portion 61 by the sliding operation. At least one uneven portion 62 is formed on the side surface 14B on the upper surface positioned in the Y direction. The second upper surface fitted portion 63 has the annular elastic body OL attached thereto.

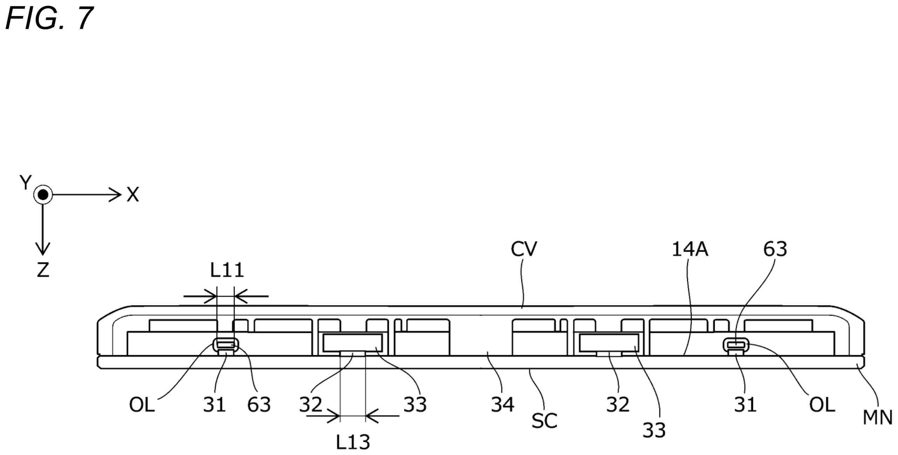

Next, fitting between the second housing upper surface fitting portion 30 of the cover CV and the first housing upper surface fitted portion 60 of the monitor MN will be described with reference to Fig. 7. Fig. 7 is an A-A cross-sectional view illustrating an example of the fitting between the monitor MN and the cover CV on the upper surface of the electronic device TB. Fig. 8 is an enlarged view of a main portion of a B-B cross section illustrating the example of the fitting between the monitor MN and the cover CV on the upper surface of the electronic device TB.

When the cover CV is slid in a state in which the pair of peripheral edge portions 13B along the sliding direction U are in contact with the pair of step portions 14A of the monitor MN, the second housing upper surface fitting portion 30 and the first housing upper surface fitted portion 60 of the monitor MN are fitted to each other.

Specifically, when the second housing upper surface fitting portion 30 is slid, the contact portion 34 is pressed against and comes into contact with the first upper surface fitted portion 61, the second upper surface fitting portion 32 enters and fits between the step portion 14A and the uneven portion 62, and the first upper surface fitting portion 31 enters and fits between the step portion 14A and the annular elastic body OL attached to the second upper surface fitted portion 63. Here, a length L13 of the second upper surface fitting portion 32 in the X direction is larger than a length L12 (see Fig. 6) of the uneven portion 62 in the X direction. Accordingly, in the electronic device TB, a contact area between the uneven portion 62 and the vibration absorbing member 33 can be increased, and the vibration between the cover CV and the monitor MN can be more effectively absorbed.

Accordingly, the electronic device TB can absorb vibration or rattling in the Y direction by the vibration absorbing member 33, and can regulate vibration or rattling in the Z direction by holding the first upper surface fitting portion 31 fitted between the step portion 14A and the annular elastic body OL in the fitted state by the elastic force (restoring force) of the annular elastic body OL.

Further, in the electronic device TB, the monitor MN and the cover CV are each formed of a rigid body, and a gap may be formed at a fitting point, that is, between the step portion 14A and the peripheral edge portion 13B facing each other due to an individual difference based on a dimensional tolerance of the monitor MN and the cover CV. Even in such a case, in the electronic device TB, the peripheral edge portion 13B of the cover CV is biased toward the step portion 14A of the monitor MN via the first side surface fitting portion 21 by the restoring force of the annular elastic body OL, so that the gap can be filled between the peripheral edge portion 13B of the cover CV and the step portion 14A of the monitor MN, and vibration or rattling in the Z direction can be regulated. Therefore, even when the monitor MN and the cover CV are each formed of a rigid body, the electronic device TB can fit the three sides of the cover CV (that is, the second housing side surface fitting portions 20 and the second housing upper surface fitting portion 30) to the upper surface of the monitor MN (that is, the first housing side surface fitted portions 50 and the first housing upper surface fitted portion 60) without screws.

In the electronic device TB, one side in the direction opposite to the Y direction of the peripheral edge portions of the monitor MN and the cover CV is screwed and fixed by screws 11A and 11B. In such a case, in the electronic device TB, a moment force centered at screwed points of the screws 11A and 11B is the largest on the upper surface. Therefore, even when an impact or vibration is applied to the electronic device TB, the electronic device TB can absorb the moment force acting on the fitting portion between the monitor MN and the cover CV on the upper surface side by the vibration absorbing member 33 provided on the upper surface.

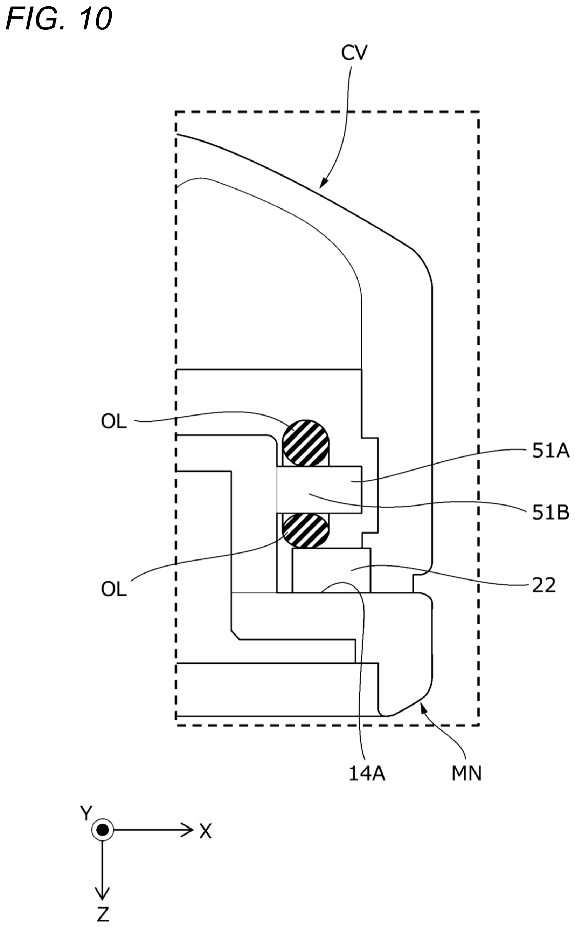

Next, fitting between the monitor MN and the cover CV by the sliding operation will be described with reference to Figs. 9 and 10. Fig. 9 is an enlarged view of a main portion of a C-C cross section illustrating an example of the fitting between the monitor MN and the cover CV on a side surface of the electronic device TB. Fig. 10 is an enlarged view of a main portion of a D-D cross section illustrating a state of the first side surface fitted portion 51, the annular elastic body OL, and the first side surface fitting portion 21 during fitting.

When the cover CV is slid in the sliding direction U in a state in which the peripheral edge portion 13B along the longitudinal direction is placed on the step portion 14A along the longitudinal direction of the monitor MN, the pair of second housing side surface fitting portions 20 and the first housing side surface fitted portions 50 of the pair of monitors MN are fitted to each other.

Specifically, when the second housing side surface fitting portion 20 is slid, the first side surface fitting portion 21 enters and fits between the step portion 14A and the annular elastic body OL attached to the second upper surface fitted portion 63, and the second side surface fitting portion 22 enters and fits between the step portion 14A and the second side surface fitted portion 52.

When the second side surface fitting portion 22 enters between the annular elastic body OL and the step portion 14A by the sliding operation, the annular elastic body OL is crushed in a direction opposite to the Z direction by the second side surface fitting portion 22. The annular elastic body OL biases the second side surface fitting portion 22 in the Z direction by the elastic force (restoring force). Accordingly, in the electronic device TB, the peripheral edge portion 13B along the longitudinal direction of the cover CV is biased in the Z direction, and is in contact with the step portion 14A along the longitudinal direction of the monitor MN.

Accordingly, in the electronic device TB, the first side surface fitting portion 21 fitted between the step portion 14A and the annular elastic body OL is held in the fitted state by the restoring force of the annular elastic body OL.

In the electronic device TB, the monitor MN and the cover CV are each formed of a rigid body, and a gap may be formed at a fitting point due to an individual difference based on a dimensional tolerance of the monitor MN and the cover CV. Even in such a case, in the electronic device TB, the peripheral edge portion 13B of the cover CV is biased toward the step portion 14A of the monitor MN via the second side surface fitting portion 22 by the restoring force of the annular elastic body OL, so that the gap can be filled between the peripheral edge portion 13B of the cover CV and the step portion 14A of the monitor MN, and vibration or rattling in the Z direction can be regulated.

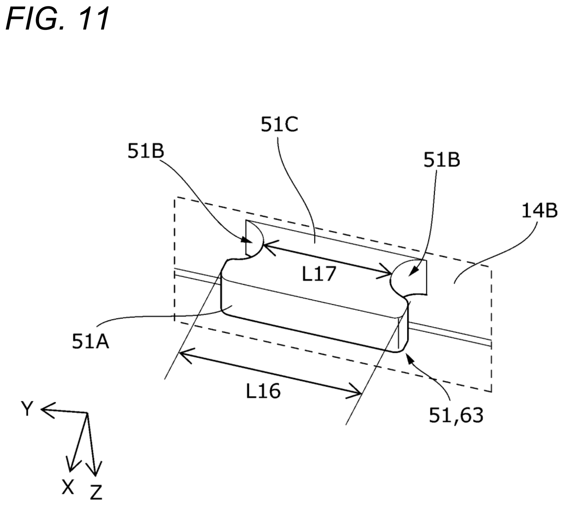

Next, the first side surface fitted portion 51 will be described with reference to Fig. 11. Fig. 11 is a diagram illustrating an example of the first side surface fitted portion 51. Since the second upper surface fitted portion 63 has the same configuration and size as the first side surface fitted portion 51, the description thereof will be omitted here.

The first side surface fitted portion 51 is provided on the side surface 14B of the monitor MN. The first side surface fitted portion 51 includes a retaining portion 51A and a connecting portion 51C that connects the monitor MN and the retaining portion 51A, and is formed such that the retaining portion 51A and the connecting portion 51C are substantially T-shaped when viewed from the Z direction. The connecting portion 51C is formed with recesses 51B on both sides in a direction along the side surface 14B of the monitor MN.

In the first side surface fitted portion 51, the annular elastic body OL is rotatably attached in a recess formed by the two recesses 51B. The recess 51B is formed such that a length L16 of the retaining portion 51A is larger than a length L17 of the connecting portion (a length between the recess 51B and the recess 51B) in the direction along the side surface 14B of the monitor MN (sliding direction U). Accordingly, the retaining portion 51A functions to retain the annular elastic body OL attached to the recess 51 B.

The first side surface fitted portion 51 may be formed in a substantially L shape when viewed from the Z direction. In such a case, in the connecting portion 51C, the recess 51B is formed only on one side of the connecting portion 51C in the direction along the side surface 14B of the monitor MN.

### (Modification of Embodiment)

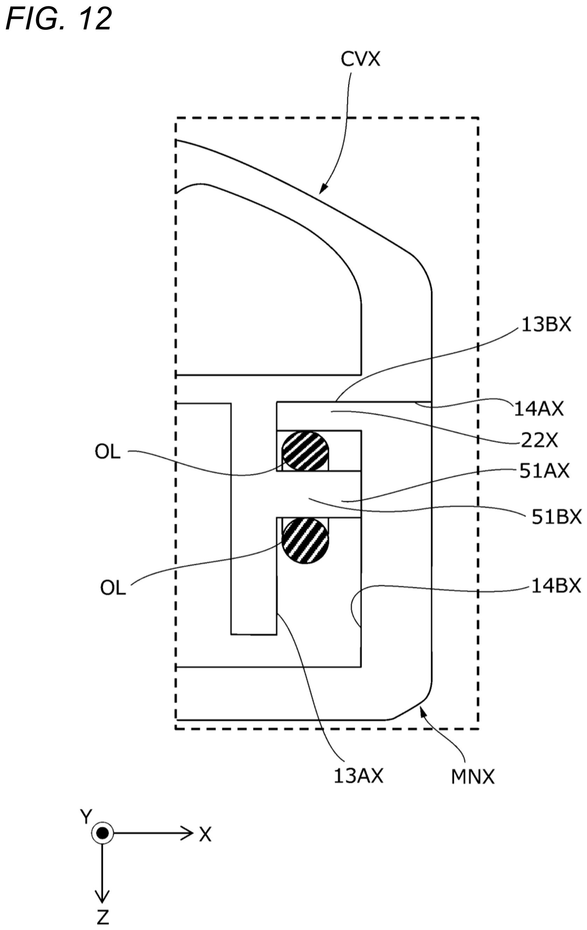

Next, as a modification of the electronic device TB, a fitting structure when the fitting relation between the cover CV and the monitor MN is reversed will be described with reference to Fig. 12. Fig. 12 is an enlarged view of a main portion of a B-B cross section illustrating an example of fitting between a monitor MNX and a cover CVX in the modification of the embodiment. In Fig. 12, in order to simplify the description, only the fitting between a first side surface fitted portion 51X and a second side surface fitting portion 22X is illustrated, and only the fitting between the first side surface fitted portion 51X and the second side surface fitting portion 22X is described.

The cover CVX in the modification of the embodiment includes, on an inner surface 13AX, first side surface fitted portions 51X and second upper surface fitted portions 63X corresponding to the first side surface fitted portion 51 and the second upper surface fitted portion 63 of the monitor MN, respectively. The monitor MNX in the modification includes, on a side surface 14B, second side surface fitting portions 22X and first upper surface fitting portions 31X corresponding to the second side surface fitting portion 22 and the first upper surface fitting portion 31 of the cover CV, respectively.

In the electronic device TB according to the modification of the embodiment, the inner surface 13AX corresponds to the inner surface 13A of the embodiment, a peripheral edge portion 13BX corresponds to the peripheral edge portion 13B of the embodiment, a step portion 14AX corresponds to the step portion 14A of the embodiment, and a side surface 14BX corresponds to the side surface 14B of the embodiment.

Similarly to the first side surface fitted portion 51 in the embodiment, the first side surface fitted portion 51X includes a retaining portion 51AX and a recess 52BX. The annular elastic body OL is rotatably attached in the recess 52X. Since the annular elastic body OL in the modification of the embodiment is the same as the annular elastic body OL in the embodiment, the description thereof will be omitted.

The second side surface fitting portion 22X enters and fits between the step portion 14AX and the annular elastic body OL by a sliding operation.

As described above, the electronic device TB according to the embodiment includes the monitor MN (an example of the first housing), the cover CV (an example of the second housing) including the second side surface fitting portion 22 and the first upper surface fitting portion 31 (an example of the fitting portion), and the annular elastic body OL (an example of an annular body). The monitor MN includes at least one first side surface fitted portion 51 and at least one second upper surface fitted portion 63 (examples of the fitted portion) that are fitted to the second side surface fitting portion 22 and the first upper surface fitting portion 31 when the monitor MN is slid in a first direction (specifically, a direction opposite to the Y direction and in which the adapter AD is connected), and the step portion 14A (an example of the first housing side peripheral edge portion) provided on the peripheral edge of the monitor MN. The annular elastic body OL is positioned between the first side surface fitted portion 51 and the step portion 14A and between the second upper surface fitted portion 63 and the step portion 14A during fitting.

Accordingly, in the electronic device TB according to the embodiment, since the monitor MN and the cover CV can be integrally assembled without using components such as screws, an increase in the number of components mounted on the electronic device TB can be prevented. In addition, since the monitor MN and the cover CV of the electronic device TB are biased toward each other by the annular elastic body OL having elasticity, even when the monitor MN or the cover CV vibrates due to an external force, the vibration can be absorbed by the annular elastic body OL, and rattling between the monitor MN and the cover CV after assembly can be more effectively prevented.

One of the monitor MN and the cover CV of the electronic device TB according to the embodiment further includes a display surface (display portion SC) configured to display information to a user. The step portion 14A is formed by a surface substantially parallel to the display surface. Accordingly, the electronic device TB according to the embodiment can assist in visually checking whether the monitor MN and the cover CV are fitted to each other by assembly.

The annular elastic body OL of the electronic device TB according to the embodiment is provided on a fitting surface on which the first side surface fitted portion 51 and the second upper surface fitted portion 63 are fitted to the second side surface fitting portion 22 and the first upper surface fitting portion 31 by the slide. The first side surface fitted portion 51 and the second upper surface fitted portion 63 are configured to be fitted to the second side surface fitting portion 22 and the first upper surface fitting portion 31 via the annular elastic body OL by the slide. Accordingly, even when the monitor MN or the cover CV vibrates due to an external force, the electronic device TB according to the embodiment can absorb the vibration between the monitor MN and the cover CV by the annular elastic body OL, and thus can more effectively prevent rattling between the monitor MN and the cover CV after assembly.

The annular elastic body OL of the electronic device TB according to the embodiment has an annular shape and is provided so as to surround peripheries of the first side surface fitted portion 51 and the second upper surface fitted portion 63. Accordingly, in the electronic device TB according to the embodiment, a component for attaching the annular elastic body OL to the first side surface fitted portion 51 and the second upper surface fitted portion 63 can be omitted, and an increase in the number of components mounted on the electronic device TB can be prevented.

In addition, the first side surface fitted portion 51 and the second upper surface fitted portion 63 of the electronic device TB according to the embodiment include the retaining portion 51A and the connecting portion 51C connecting the retaining portion 51A with the monitor MN provided with the first side surface fitted portion 51 and the second upper surface fitted portion 63. The length of the retaining portion 51A is larger than the length of the connecting portion 51C in a direction of the slide. The annular elastic body OL is provided so as to surround the connecting portion 51C. Accordingly, the electronic device TB according to the embodiment can bias the monitor MN and the cover CV in a direction in which the monitor MN and the cover CV come into contact with each other and can absorb vibration between the monitor MN and the cover CV.

In addition, in the first side surface fitted portion 51 and the second upper surface fitted portion 63 of the electronic device TB according to the embodiment, the retaining portion 51A and the connecting portion 51C are connected to form a substantial T-shape. As a result, the electronic device TB according to the embodiment can prevent the annular elastic body OL from coming off without using a component for preventing the annular elastic body OL from coming off the first side surface fitted portion 51 and the second upper surface fitted portion 63.

The electronic device TB according to the embodiment further includes at least one first side surface fitting portion 21 and at least one second upper surface fitting portion 32 (examples of other fitting portion) provided in the cover CV, and at least one second side surface fitted portion 52 and at least one uneven portion 62 (examples of other fitted portion) provided in the monitor MN and configured to be fitted to the first side surface fitting portion 21 and the second upper surface fitting portion 32 by being slid along the first direction. The outer shapes of the second side surface fitted portion 52 and the uneven portion 62 are larger than the outer shapes of the first side surface fitted portion 51 and the second upper surface fitted portion 63. Accordingly, the electronic device TB according to the embodiment can effectively prevent the annular elastic body OL from being erroneously attached to the second side surface fitted portion 52 and the second upper surface fitted portion 63 when the annular elastic body OL is attached or replaced.

In addition, the second side surface fitting portion 22 and the first upper surface fitting portion 31 of the electronic device TB according to the embodiment are provided on the second housing side peripheral edge portion 13 that is the peripheral edge of the cover CV, and the first housing side peripheral edge portion 14 and the second housing side peripheral edge portion 13 are in contact with each other based on the fitting between the second side surface fitting portion 22 and the first side surface fitted portion 51 and the fitting between the first upper surface fitting portion 31 and the second upper surface fitted portion 63. Accordingly, in the electronic device TB according to the embodiment, the monitor MN and the cover CV can be assembled such that there is no gap due to a portion where the monitor MN and the cover CV are in contact with each other in appearance.

The monitor MN or the cover CV of the electronic device TB according to the embodiment includes the adapter receiving portion 12 that is a connection point between the electronic device TB and the adapter AD connected to the electronic device TB. The monitor MN and the cover CV are fixed at the adapter receiving portion 12. Accordingly, the electronic device TB according to the embodiment can protect the electrical or physical connection of the adapter receiving portion 12, which is a connection point to which the adapter AD or the like is connected in the peripheral edge portions of the monitor MN and the cover CV.

The monitor MN and the cover CV of the electronic device TB according to the embodiment are formed in a substantially rectangular shape. The adapter receiving portion 12 is provided on a side in the first direction of one of the monitor MN and the cover CV. The second side surface fitting portion 22, the first upper surface fitting portion 31, the first side surface fitted portion 51, and the second upper surface fitted portion 63 are provided on each side other than the first direction. Accordingly, the electronic device TB according to the embodiment can be assembled so as to be able to absorb vibration caused by an external force applied to the electronic device TB without using a component such as a screw at the peripheral edge portions of the monitor MN and the cover CV other than the connection point to which the adapter AD or the like is connected.

All of the annular elastic bodies OL of the electronic device TB according to the embodiment have the same size. Accordingly, in the electronic device TB according to the embodiment, the annular elastic body OL attached to the first side surface fitted portion 51 and the second upper surface fitted portion 63 can be shared, and maintenance can be facilitated.

The monitor MN of the electronic device TB according to the embodiment further includes the uneven portion 62 having an uneven shape on a side in a direction opposite to the first direction. The cover CV further includes the vibration absorbing member 33 on a side in the direction opposite to the first direction. The vibration absorbing member 33 comes into contact with the uneven portion 62 by the sliding along the first direction. Accordingly, the electronic device TB according to the embodiment can absorb the vibration of the electronic device TB in the direction opposite to the first direction, which is an open state, and thus can more effectively prevent rattling between the monitor MN and the cover CV after assembly. When the electronic device TB is screwed in the first direction by the screws 11A and 11B, the vibration absorbing member 33 can absorb the moment force generated around the screwed position based on the external force applied to the electronic device TB.

The cover CV of the electronic device TB according to the embodiment further includes the second upper surface fitting portion 32 (an example of the uneven fitting portion) configured to be fitted to the uneven portion 62 on the side in the direction opposite to the first direction. The length L12 of the uneven portion 62 is larger than the length L13 of the second upper surface fitting portion 32 in a direction substantially orthogonal to the first direction. Accordingly, in the electronic device TB according to the embodiment, the contact area between the uneven portion 62 and the vibration absorbing member 33 can be increased, and the vibration between the cover CV and the monitor MN can be more effectively absorbed.

The second side surface fitting portion 22 and the first upper surface fitting portion 31 of the electronic device TB according to the embodiment include the C surfaces 22A and 31A (examples of the inclined portion) that protrude from the peripheral edge portion of the cover CV and have a protruding height decreasing along the first direction. Accordingly, in the electronic device TB according to the embodiment, the second side surface fitting portion 22 and the first upper surface fitting portion 31 are easily fitted to the first side surface fitted portion 51 and the second upper surface fitted portion 63 by the slide.

The monitor MN and the cover CV of the electronic device TB according to the embodiment have rigidity. Accordingly, in the electronic device TB according to the embodiment, even when there is an individual difference based on the dimensional tolerance in the dimensions of each of the monitor MN and the cover CV, rattling between the monitor MN and the cover CV after assembly can be more effectively prevented by the annular elastic body OL having elasticity.

Although various embodiments have been described above with reference to the accompanying drawings, the present disclosure is not limited thereto. It is apparent to those skilled in the art that various modifications, corrections, substitutions, additions, deletions, and equivalents can be conceived within the scope described in the claims, and it is understood that such modifications, corrections, substitutions, additions, deletions, and equivalents also fall within the technical scope of the present disclosure. In addition, components in the various embodiments described above may be combined freely in a range without departing from the spirit of the invention.

### INDUSTRIAL APPLICABILITY

The present disclosure is useful as a presentation of an electronic device that more effectively prevents rattling of the electronic device after assembly.

### REFERENCE SIGNS LIST

**11A, 11B:** screw
12: adapter receiving portion
12A, 12B: insertion hole
13: second housing side peripheral edge portion
13A: inner surface
13B: peripheral edge portion
14: first housing side peripheral edge portion
14A: step portion
14B: side surface
15, 16: back surface portion
20: second housing side surface fitting portion
21: first side surface fitting portion
22: second side surface fitting portion
22A, 31A: C surface
30: second housing upper surface fitting portion
31: first upper surface fitting portion
32: second upper surface fitting portion
33: vibration absorbing member
34: contact portion
50: first housing side surface fitted portion
51: first side surface fitted portion
51A: retaining portion
51B: recess
51C: connecting portion
52: second side surface fitted portion
60: first housing upper surface fitted portion
61: first upper surface fitted portion
62: uneven portion
63: second upper surface fitted portion
AD: adapter
CV: cover
MN: monitor
OL: annular elastic body
SC: display portion
TB: electronic device

## Claims

1. An electronic device comprising:
a first housing;
a second housing including a fitting portion; and
an elastic body, wherein
the first housing includes
at least one fitted portion configured to be fitted to the fitting portion by being slid along a first direction, and
a first housing side peripheral edge portion provided on a peripheral edge of the first housing, and
the elastic body is positioned between the fitted portion and the first housing side peripheral edge portion during the fitting.

2. The electronic device according to claim 1, wherein
one of the first housing and the second housing further includes a display surface configured to display information to a user, and
the first housing side peripheral edge portion is formed by a surface substantially parallel to the display surface.

3. The electronic device according to claim 1, wherein
the elastic body is provided on a fitting surface on which the fitted portion and the fitting portion are fitted by the slide, and
the fitted portion is configured to be fitted to the fitting portion via the elastic body by the slide.

4. The electronic device according to claim 1, wherein
the elastic body has an annular shape and is provided so as to surround a periphery of the fitted portion.

5. The electronic device according to claim 1, wherein
the fitted portion includes a retaining portion and a connecting portion connecting the first housing provided with the fitted portion and the retaining portion,
a length of the retaining portion is larger than a length of the connecting portion in a direction of the slide, and
the elastic body is provided so as to surround the connecting portion.

6. The electronic device according to claim 5, wherein
in the fitted portion, the retaining portion and the connecting portion are connected to form a substantial T-shape.

7. The electronic device according to claim 1, further comprising:
at least one other fitting portion provided in the second housing; and
at least one other fitted portion provided in the first housing and configured to be fitted to the other fitting portion by being slid along the first direction, wherein
an outer shape of the other fitted portion is larger than an outer shape of the fitted portion.

8. The electronic device according to claim 1, wherein
the fitting portion is provided on a second housing side peripheral edge portion that is a peripheral edge of the second housing, and
the first housing side peripheral edge portion and the second housing side peripheral edge portion are in contact with each other based on fitting between the fitting portion and the fitted portion.

9. The electronic device according to claim 1, wherein
the first housing or the second housing includes an adapter receiving portion that is a connection point between the electronic device and an adapter connected to the electronic device, and
the first housing and the second housing are fixed at the adapter receiving portion.

10. The electronic device according to claim 9, wherein
the first housing and the second housing are formed in a substantially rectangular shape,
the adapter receiving portion is provided on a side in the first direction of one of the first housing and the second housing, and
the fitting portion and the fitted portion are provided on each side other than the first direction.

11. The electronic device according to claim 10, wherein
all of the elastic bodies have the same size.

12. The electronic device according to claim 10, wherein
the first housing further includes an uneven portion having an uneven shape on a side in a direction opposite to the first direction,
the second housing further includes a vibration absorbing member on a side in the direction opposite to the first direction, and
the vibration absorbing member comes into contact with the uneven portion by the slide along the first direction.

13. The electronic device according to claim 12, wherein
the second housing further includes an uneven fitting portion configured to be fitted to the uneven portion on the side in the direction opposite to the first direction, and
a length of the uneven portion is larger than a length of the uneven fitting portion in a direction substantially orthogonal to the first direction.

14. The electronic device according to claim 1, wherein
the fitting portion includes an inclined portion that protrudes from a peripheral edge portion of the second housing and has a protrusion height decreasing along the first direction.

15. The electronic device according to claim 1, wherein
the first housing and the second housing have rigidity.
